(19) Europäisches Patentamt / European Patent Office / Office européen des brevets

(11) **EP 4 546 600 A1**

(12) **EUROPEAN PATENT APPLICATION**
published in accordance with Art. 153(4) EPC

(43) Date of publication:
30.04.2025 Bulletin 2025/18

(21) Application number: 23851484.8

(22) Date of filing: 30.06.2023

(51) International Patent Classification (IPC):
H02J 7/00 (2006.01)     H01M 10/44 (2006.01)
B60L 58/10 (2019.01)

(52) Cooperative Patent Classification (CPC):
Y02T 10/70

(86) International application number:
PCT/CN2023/104958

(87) International publication number:
WO 2024/032257 (15.02.2024 Gazette 2024/07)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 10.08.2022 CN 202210959066

(71) Applicant: Sunwoda Mobility Energy Technology
Co., Ltd.
Shenzhen, Guangdong 518107 (CN)

(72) Inventors:
• WU, Tao
Shenzhen, Guangdong 518107 (CN)
• LI, Jianjie
Shenzhen, Guangdong 518107 (CN)
• YI, Xingyun
Shenzhen, Guangdong 518107 (CN)
• CHEN, Binbin
Shenzhen, Guangdong 518107 (CN)

(74) Representative: Ostriga Wirths und Vorwerk
Patentanwälte PartGmbB
Patentanwälte
Friedrich-Engels-Allee 432
42283 Wuppertal (DE)

(54) **METHOD FOR DYNAMICALLY ADJUSTING POWER, AND BATTERY MANAGEMENT SYSTEM, DEVICE, MEDIUM AND VEHICLE**

(57) A method for dynamically adjusting power, a battery management system, a device, a medium, and a vehicle are disclosed, which relate to the technical field of energy management. The method for dynamically adjusting power includes acquiring power information, calculating a discharge power integral value within a preset time threshold, calculating a discharge energy according to the power information, and determining whether it is necessary to adjust the maximum allowable output power from first time discharge power to second time discharge power, or to adjust the maximum allowable output power from the second time discharge power to the first time discharge power based on the discharge power integral value and the discharge energy. According to the embodiments, the maximum allowable output power is adjusted between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle.

**EP 4 546 600 A1**

Acquire power information ⟋S110

Calculate a discharge power integral value within a preset time threshold ⟋S120

Calculate a discharge energy according to the power information ⟋S130

Determine whether a power regulation condition is met based on the discharge power integral value and the discharge energy ⟋S140

Adjust the maximum allowable output voltage according to the power regulation condition ⟋S150

FIG. 2

## Description

### TECHNICAL FIELD

The present disclosure relates to the technical field of energy management, and in particular, to a method for dynamically adjusting power, a battery management system, a device, a medium, and a vehicle.

### BACKGROUND

With the development of the new energy vehicle field, lithium batteries have become increasingly widespread as the primary energy storage devices. Lithium batteries have the characteristics of high energy density and low power density, and can meet the load power requirements well.

In the related art, a more commonly used discharge power control strategy in battery management systems is to output relatively conservative discharge power, that is, to match the long-term discharge power with a certain power limitation strategy to meet the basic power requirements of the entire vehicle. However, this discharge power control strategy cannot meet the short-term high-power discharge requirements of the entire vehicle. For example, the vehicle's secondary acceleration requires greater power in a shorter period of time. At this time, the battery management systems cannot provide the greater power, which will affect the acceleration performance of the entire vehicle, so that battery management needs to output greater power, that is, short-term discharge power is provided to the entire vehicle for acceleration. Simply adjusting the output to short-term discharge power, however, may lead to prolonged short-term high-power discharge, resulting in an undervoltage condition.

### SUMMARY

The main objective of the embodiments of the present disclosure is to provide a method for dynamically adjusting power, a battery management system, a device, a medium, and a vehicle. The maximum allowable output power is controlled by introducing short-term discharge power, in conjunction with the actual state of the current battery and the current actual power information, and coupled with the method for dynamically adjusting power, so as to meet the power requirements of the entire vehicle under different working conditions.

In order to achieve the above objective, in a first aspect, an embodiment of the present disclosure provides a method for dynamically adjusting power, including:

acquiring power information, the power information including a first time discharge power, a second time discharge power, and a maximum allowable output power;
calculating a discharge power integral value within a preset time threshold;
calculating a discharge energy according to the power information;
determining whether a power regulation condition is met based on the discharge power integral value and the discharge energy; and
adjusting the maximum allowable output power from the first time discharge power to the second time discharge power or adjusting the maximum allowable output power from the second time discharge power to the first time discharge power in response to the power regulation condition being met.

In some embodiments, the acquiring power information includes:

acquiring a current working state and a cutoff voltage, the current working state including: a current state of charge and a current working temperature;
calculating a power value required to continuously discharge to the cutoff voltage within a first preset time in the current working state as the first time discharge power; and
calculating a power value required to continuously discharge to the cutoff voltage within a second preset time in the current working state as the second time discharge power, the first preset time being shorter than the second preset time.

In some embodiments, the preset time threshold includes: a first time threshold and a second time threshold; the discharge power integral value includes: a first discharge power integral value and a second discharge power integral value; the calculating a discharge power integral value within a preset time threshold includes:

acquiring an actual power at each time sampling point within the first time threshold;
summating the actual power within the first time threshold to obtain the first discharge power integral value;

acquiring an actual power at each time sampling point within the second time threshold; and

summating the actual power within the second time threshold to obtain the second discharge power integral value.

In some embodiments, the discharge energy includes: first time discharge energy and second time discharge energy corresponding to the first time discharge power and the second time discharge power, respectively; the calculating a discharge energy according to the power information includes:

acquiring a cutoff voltage;

calculating the first time discharge energy output by discharging to the cutoff voltage at the first time discharge power; and

calculating the second time discharge energy output by discharging to the cutoff voltage at the second time discharge power.

In some embodiments, the power regulation condition includes a first power regulation condition; the determining whether a power regulation condition is met based on the discharge power integral value and the discharge energy includes:

acquiring a first adjustment trigger parameter and a second adjustment trigger parameter;

determining whether a first adjustment trigger condition is met based on the first discharge power integral value, the first adjustment trigger parameter, and the first time discharge energy;

determining whether a second adjustment trigger condition is met based on the second discharge power integral value, the second adjustment trigger parameter, and the second time discharge energy; and

determining that the first power regulation condition is met in response to either of the first adjustment trigger condition and the second adjustment trigger condition being met.

In some embodiments, in case that the first power regulation condition is met, the adjusting the maximum allowable output power from the first time discharge power to the second time discharge power includes:

acquiring a first parameter; and

adjusting the maximum allowable output power from the first time discharge power down to the second time discharge power based on the first parameter.

In some embodiments, the power regulation condition includes a second power regulation condition; the determining whether a power regulation condition is met based on the discharge power integral value and the discharge energy includes:

acquiring a first recovery trigger parameter and a second recovery trigger parameter;

determining, based on the first discharge power integral value, the first recovery trigger parameter, and the first time discharge energy, whether a first recovery trigger condition is met;

determining, based on the second discharge power integral value, the second recovery trigger parameter, and the second time discharge energy, whether the second recovery trigger condition is met; and

in response to both the first recovery trigger condition and the second recovery trigger condition being met, determining that the second power regulation condition is met.

In some embodiments, in case that the first power regulation condition is met, the adjusting the maximum allowable output power from the first time discharge power to the second time discharge power includes:

acquiring a first parameter; and

adjusting the maximum allowable output power from the first time discharge power down to the second time discharge power based on the first parameter.

In some embodiments, in case that the second power regulation condition is met, the adjusting the maximum allowable output power from the second time discharge power to the first time discharge power includes:

acquiring a second parameter; and

adjusting the maximum allowable output power from the second time discharge power up to the first time discharge power based on the second parameter.

In order to achieve the above objective, in a second aspect, an embodiment of the present disclosure provides an apparatus for dynamically adjusting power, including:

a power acquisition unit, configured to acquire power information, the power information including a first time discharge power, a second time discharge power, and a maximum allowable output power;
a power integral value calculation unit, configured to calculate a discharge power integral value within a preset time threshold;
a discharge energy calculation unit, configured to calculate a discharge energy according to the power information;
a determination unit, configured to determine whether a power regulation condition is met based on the discharge power integral value and the discharge energy; and
a regulation unit, configured to, adjust the maximum allowable output power from the first time discharge power to the second time discharge power or adjust the maximum allowable output power from the second time discharge power to the first time discharge power in response to the power regulation condition being met.

In order to achieve the above objective, in a third aspect, an embodiment of the present disclosure provides a battery management system, including: a processor and a memory;

the memory being configured to store programs;
the processor being configured to execute, according to the programs, the method for dynamically adjusting power in the first aspect to adjust a power of a battery.

In order to achieve the above objective, in a fourth aspect, an embodiment of the present disclosure provides a computer-readable storage medium, storing computer-executable instructions, the computer-executable instructions being used to execute the method for dynamically adjusting power in the first aspect.

In order to achieve the above objective, in a fifth aspect, an embodiment of the present disclosure provides a vehicle, including:

a battery; and
the battery management system in the third aspect, the battery management system being electrically connected to the battery.

Embodiments of the present disclosure provide a method for dynamically adjusting power, a battery management system, a device, a medium, and a vehicle. The method for dynamically adjusting power includes acquiring power information, calculating a discharge power integral value within a preset time threshold, calculating a discharge energy according to the power information, and determining whether it is necessary to adjust the maximum allowable output power from a first time discharge power to a second time discharge power, or to adjust the maximum allowable output power from the second time discharge power to the first time discharge power based on the discharge power integral value and the discharge energy. According to the embodiments, the maximum allowable output power is adjusted between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle.

**BRIEF DESCRIPTION OF DRAWINGS**

FIG. 1 is a schematic structural diagram of a battery management system provided by an embodiment of the present disclosure.
FIG. 2 is a flowchart of a method for dynamically adjusting power provided by an embodiment of the present disclosure.
FIG. 3 is a flowchart of the method for dynamically adjusting power provided by an embodiment of the present disclosure.
FIG. 4 is a flowchart of the method for dynamically adjusting power provided by an embodiment of the present disclosure.
FIG. 5 is a schematic diagram of data access of a first array in the method for dynamically adjusting power provided by an embodiment of the present disclosure.
FIG. 6 is a schematic diagram of data access of a second array in the method for dynamically adjusting power provided by an embodiment of the present disclosure.

FIG. 7 is a flowchart of the method for dynamically adjusting power provided by an embodiment of the present disclosure.

FIG. 8 is a flowchart of the method for dynamically adjusting power provided by an embodiment of the present disclosure.

FIG. 9 is a flowchart of the method for dynamically adjusting power provided by an embodiment of the present disclosure.

FIG. 10 is a flowchart of the method for dynamically adjusting power provided by an embodiment of the present disclosure.

FIG. 11 is a flowchart of the method for dynamically adjusting power provided by an embodiment of the present disclosure.

FIG. 12 is a schematic diagram of power information in the method for dynamically adjusting power provided by an embodiment of the present disclosure.

FIGS. 13a-13c are schematic diagrams provided by yet another embodiment of the present disclosure.

FIG. 14 is a structural block diagram of an apparatus for dynamically adjusting power provided by an embodiment of the present disclosure.


## DETAILED DESCRIPTION

In order to make the objectives, technical solutions, and advantages of the present disclosure clearer and more understandable, the present disclosure will be further described in detail below in conjunction with the accompanying drawings and embodiments. It is to be understood that the specific embodiments described here are merely used to explain the present disclosure and are not intended to limit the present disclosure.

It needs to be noted that although the functional modules are divided in the apparatus schematic diagrams and the logical sequence is shown in the flowcharts, in some cases, the apparatus may have different module divisions, or the steps shown or described in the flowcharts may be performed in an different order.

Unless otherwise defined, all technical and scientific terms used herein have the same meaning as commonly understood by those of ordinary skills in the art. The terms used herein are for the purpose of describing embodiments of the present disclosure merely and are not intended to limit the present disclosure.

Battery state of charge (SOC) indicates the charging ratio of a lithium battery, and is also known as state of charge or remaining capacity, indicating the ratio of the remaining capacity of a battery after being used for a period of time or left unused for a long time to its fully charged capacity, commonly expressed as a percentage with its value range of 0-1. When SOC=0, it means that the battery is fully discharged. When SOC=1, it means that the battery is fully charged. The selection of SOC usage interval should comprehensively balance various influencing factors (total energy design, battery box design, entire vehicle weight, cruising range, etc.), and thus a comprehensive and balanced selection is required to determine the best solution for SOC usage.

With the development of the new energy vehicle field, lithium batteries have become increasingly widespread as the primary energy storage devices. Lithium batteries have the characteristics of high energy density and low power density, and can meet the load power requirements well. With the large-scale application of lithium batteries, the battery performance thereof has attracted much attention. As the application scenarios of power lithium batteries continue to expand, hybrid vehicles are also strongly promoted in addition to pure electric vehicles, putting forward higher requirements to the power performance management of lithium batteries.

In the related art, a more commonly used discharge power control strategy in battery management systems is to output relatively conservative discharge power, that is, to match the long-term discharge power with a certain power limitation strategy to meet the basic power requirements of the entire vehicle. However, this discharge power control strategy cannot meet the short-term high-power discharge requirements of the entire vehicle. For example, the vehicle's secondary acceleration requires a greater power in a shorter period of time. At this time, the battery management systems cannot provide the greater power, which will affect the acceleration performance of the entire vehicle, so that battery management needs to output greater power, that is, short-term discharge power is provided to the entire vehicle for acceleration. Simply adjusting the output to short-term discharge power, however, may lead to prolonged short-term high-power discharge, resulting in an undervoltage condition. Therefore, it is necessary to introduce a method for dynamically adjusting discharge power to dynamically adjust, according to the actual power used by the entire vehicle, the discharge power output by the battery management system, and adjust short-term discharge power to long-term discharge power. On the premise of protecting the battery, the power requirements of the entire vehicle under different working conditions are met.

Based on this, embodiments of the present disclosure provide a method for dynamically adjusting power, a battery management system, a device, a medium, and a vehicle. Power information is acquired, a discharge power integral value within a preset time threshold is calculated, a discharge energy is calculated according to the power information, and it is determined whether it is necessary to adjust a maximum allowable output power from a first time discharge power to a second time discharge power, or to adjust the maximum allowable output power from the second time discharge power to the first time discharge power based on the discharge power integral value and the discharge energy.

According to the embodiments, the maximum allowable output power is adjusted between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle. It is suitable for battery management systems of different types of new energy vehicles such as pure electric vehicles and hybrid vehicles to meet the power requirements of the entire vehicle under different working conditions.

Embodiments of the present disclosure provide a method for dynamically adjusting power, a battery management system, a device, a medium, and a vehicle, which are specifically illustrated through the following embodiments. First, the method for dynamically adjusting power in an embodiment of the present disclosure is described.

The method for dynamically adjusting power provided by an embodiment of the present disclosure relates to the technical field of power management, and in particular, to the technical field of battery power management. The method for dynamically adjusting power provided by the embodiment of the present disclosure may be applied to a terminal or a server, or may be software running in a terminal or a server. The terminal communicates with the server through a network. The method for dynamically adjusting power may be executed by the terminal or the server, or by the terminal and the server in cooperation.

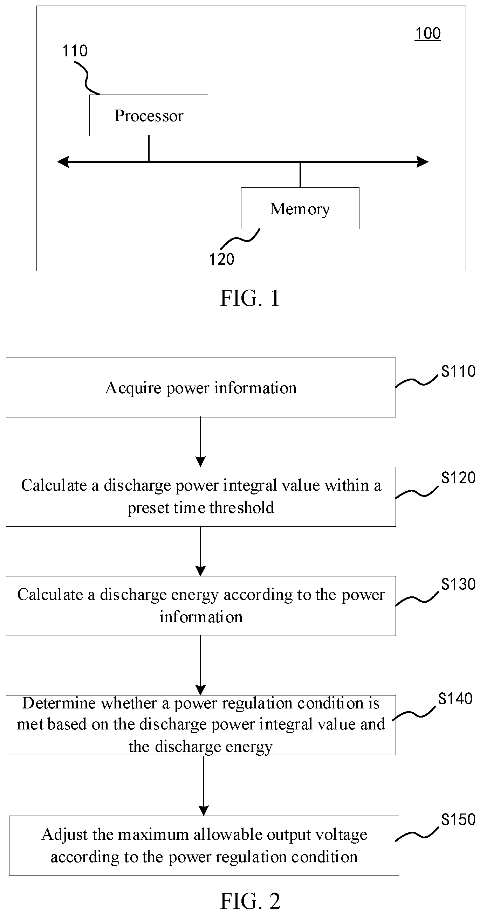

First, the method for dynamically adjusting power is illustrated. Referring to FIG. 1 showing a schematic structural diagram of a battery management system 100 for a method for dynamically adjusting power provided by an embodiment of the present disclosure, the battery management system 100 may be mounted on an electric vehicle or a hybrid vehicle. Structurally, the battery management system 100 may include: a processor **110** and a memory 120.

In this embodiment, the processor 110 and the memory 120 are electrically connected directly or indirectly to realize data transmission or interaction. For example, these elements may be electrically connected to each other through one or more communication buses or signal lines. The above method includes at least one software module that may be stored in the memory 120 or solidified in the battery management system 100 in the form of software or firmware. The processor 110 is configured to execute executable modules stored in the memory 120. The processor 110 is connected to the battery or battery components, and after receiving an execution instruction, executes the computer program of the method for dynamically adjusting power to adjust the power of the battery.

In this embodiment, the processor 110 may be an integrated circuit chip with signal processing capabilities. The processor 110 may also be a general-purpose processor, for example, a Digital Signal Processor (DSP), an Application Specific Integrated Circuit (ASIC), a discrete gate or transistor logic device, or a discrete hardware component, which can implement or execute each method, step and logical block diagram disclosed in the embodiments of the present disclosure. Furthermore, the general-purpose processor may be a microprocessor or any conventional processor or the like. The memory 120 may be, but is not limited to, a Random Access Memory (RAM), a Read Only Memory (ROM), a Programmable Read-Only Memory (PROM), an Erasable Programmable Read-Only Memory (EPROM), and an Electric Erasable Programmable Read-Only Memory (EEPROM). The memory 120 is used to store a program, and the processor 110 executes the program after receiving the execution instruction.

In an embodiment, the battery management system 100 may be mounted on a smart vehicle-mounted device. The smart vehicle-mounted device adjusts the maximum allowable output power between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle. It is suitable for the power regulation process of the entire vehicle under different working conditions.

In an embodiment, the battery management system 100 may also be loaded in a server. The server may be an independent server, or a cloud server that provides basic cloud computing services such as cloud services, cloud databases, cloud computing, cloud functions, cloud storage, network services, cloud communications, middleware services, domain name services, security services, and big data and artificial intelligence platforms. The server side of the battery management system 100 may be mounted on the server, through which it can interact with an in-vehicle management device. The in-vehicle management device is connected to the battery. For example, corresponding software may be mounted on the server side. The software may be applications, etc. that implement the method for dynamically adjusting power, but are not limited to the above forms. The in-vehicle management device and the server may be connected through Bluetooth, a USB, a network or other communication connection methods, which is not limited here in this embodiment.

It needs to be noted that the structure shown in FIG. 2 is merely illustrative. The battery management system 100 provided by an embodiment of the present disclosure may also have fewer or more components than that shown in FIG. 2, or have a different configuration than that shown in FIG. 2. In addition, each component shown in FIG. 2 may be implemented by software, hardware, or a combination thereof.

FIG. 2 is an optional flowchart of a method for dynamically adjusting power provided by an embodiment of the present disclosure. The method in FIG. 2 may include, but is not limited to, step S110 to step S170. Meanwhile, it can be understood that the order of step S110 to step S170 in FIG. 2 is not specifically limited in this embodiment, and the order of steps may be adjusted or certain steps may be reduced or added according to actual needs.

Step S110: power information is acquired.

In an embodiment, the power information includes: a first time discharge power Pwr_S1, a second time discharge power Pwr_S2, and a maximum allowable output power Pwr_BMS_Out. The maximum allowable output power Pwr_BMS_Out represents the maximum allowable discharge power output in the battery management system, which is used to limit the maximum discharge power that the vehicle control unit (VCU) can output. In the embodiment of the present disclosure, the maximum allowable output power Pwr_BMS_Out is dynamically adjusted based on the first time discharge power Pwr_S1 and the second time discharge power Pwr_S2, combined with the current operating state of the entire vehicle and the actual power usage.

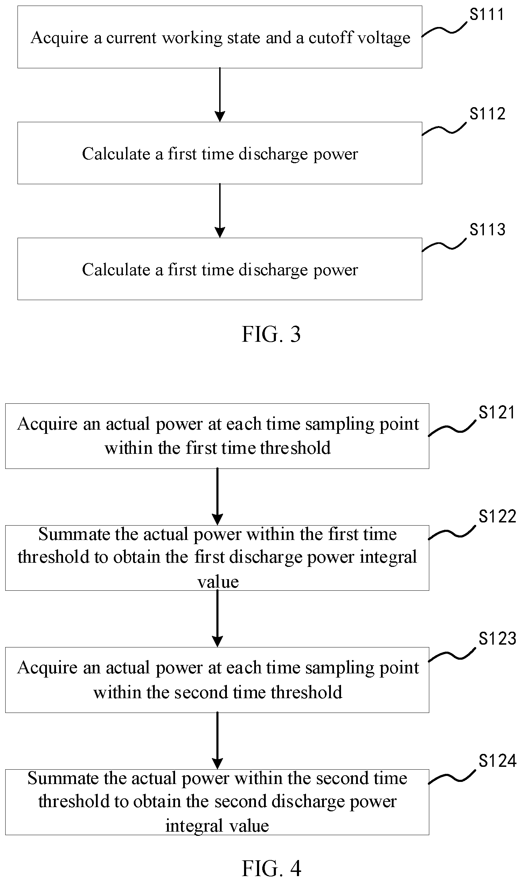

In an embodiment, referring to FIG. 3, step S110 includes, but is not limited to, steps S111 to step S113.

Step S111, a current working state and a cutoff voltage are acquired.

In an embodiment, the cutoff voltage is the discharge cutoff voltage of the battery, and the current working state includes: a current state of charge (SOC) and a current working temperature. Since the battery power is related to the current SOC and the current working temperature, it is necessary to acquire the current SOC and the current working temperature when performing subsequent power regulation, thereby improving the regulation accuracy.

Step S112, a first time discharge power is calculated.

In an embodiment, a power value required to continuously discharge to the cutoff voltage within first preset time in the current working state is used as the first time discharge power.

Step S113, a second time discharge power is calculated.

In an embodiment, a power value required to continuously discharge to the cutoff voltage within second preset time in the current working state is used as the second time discharge power, and the first preset time is shorter than the second preset time.

In an embodiment, the first preset time is shorter, and the corresponding first time discharge power Pwr_S1 is also called short-term discharge power. The second preset time is longer than the first preset time, and the corresponding second time discharge power Pwr_S2 is also called long-term discharge power. In this embodiment, the value of the first time discharge power Pwr_S1 is greater than that of the second time discharge power Pwr_S2.

In an embodiment, the first preset time and the second preset time are set based on actual operating conditions or prior knowledge obtained based on actual test data for different vehicle models. For example, the first preset time t1 may be 2s, and the second preset time t2 may be 10s, that is, the corresponding first time discharge power Pwr_S1 may also be expressed as Pwr_2S; the second preset time is longer than the first preset time, and the corresponding second time discharge power Pwr_S2 may also be expressed as Pwr_10S. It can be understood that this embodiment merely illustrates the first preset time and the second preset time, and does not mean to limit them.

In an embodiment, in step S112, the power value required to continuously discharge to the cutoff voltage within the first preset time in the current working state is calculated as the first time discharge power, that is, based on the current SOC and the current working temperature, when the battery is discharged to the cutoff voltage for first preset time (for example, 2S) in a constant power state, the maximum power value used is taken as the short-term first time discharge power Pwr_S1.

In an embodiment, in step S113, the power value required to continuously discharge to the cutoff voltage within the second preset time in the current working state is calculated as the second time discharge power, that is, based on the current SOC and the current working temperature, when the battery is discharged to the cutoff voltage for a second preset time (for example, 10S) in the constant power state, the maximum power value used is taken as the long-term second time discharge power Pwr_S2.

In an embodiment, a power lookup table may also be generated according to the corresponding relationship between the first time discharge power Pwr_S1 and the second time discharge power Pwr_S2 in different SOCs and working temperatures, and the corresponding first time discharge power Pwr_S1 and the second time discharge power Pwr_S2 may be queried at any time as needed. The acquisition methods of the first time discharge power Pwr_S1 and the second time discharge power Pwr_S2 are not specifically limited in the present disclosure.

Step S120: a discharge power integral value within a preset time threshold is calculated.

In an embodiment, the preset time threshold includes two time threshold windows, which are: a first time threshold T1 and a second time threshold T2. In this embodiment, the discharge power integral value within the preset time threshold is calculated, that is, the integral amount of the actual discharge power within the two time threshold windows is counted, and the statistically obtained integral amount is used as part of the basis for subsequent power adjustment.

In an embodiment, the actual discharge power is the actual power during vehicle operation and is expressed as Pwr_user. In this embodiment, the calculation method of the actual power Pwr_user is:

$$Pwr\_user = total\ voltage * current,$$

where the total voltage is the current voltage of the battery, and the current is the present current of the battery. Since the battery has two states of charging and discharging, in this embodiment, the charging current is defined as positive and the discharging current as negative. That is, when Pwr_user>0, it means that the actual power is discharge power, and when Pwr_user<0, it means that the actual power is regenerative power or charging power. In this embodiment, the power is adjusted during driving, so that the calculation of the actual power is also performed in the driving mode. Therefore, the actual power Pwr_user<0 represents regenerative power.

In an embodiment, the first time threshold T1 and the second time threshold T2 are determined based on actual needs or prior knowledge obtained based on actual test data for different vehicle models. For example, the first time threshold T1 may be 3s, and the second time threshold T2 may be 15s. It can be understood that this embodiment merely illustrates the first preset time and the second preset time, and does not mean to limit them.

Referring to FIG. 4, step S120 includes, but is not limited to, step S121 to step S124.

Step S121: an actual power at each time sampling point within the first time threshold is acquired.

Step S122: the actual power within the first time threshold is summated to obtain the first discharge power integral value.

Step S123: an actual power is acquired at each time sampling point within the second time threshold.

Step S124: the actual power within the second time threshold is summated to obtain the second discharge power integral value.

In an embodiment, the number of time sampling points within the first time threshold T1 is first acquired. The calculation process of the number of time sampling points is expressed as:

$$number\ of\ time\ sampling\ points = first\ time\ threshold\ window\ size / scheduling\ cycle$$

In this embodiment, the scheduling cycle refers to the cycle for dynamic power adjustment, which can be set according to actual conditions, and for example, may be 100 ms. Therefore, when the first time threshold T1 is 3s, sampling is performed 10 times every second, and the number of corresponding time sampling points is 30.

In an embodiment, the actual power Pwr_user is recorded every time it is scheduled, and the actual power Pwr_user at each time sampling point within the first time threshold T1 is acquired and stored in a first array AT1.

Correspondingly, in an embodiment, when the second time threshold T2 is 15s, sampling is performed 10 times every second, and the number of corresponding time sampling points is 150.

In an embodiment, the actual power Pwr_user is recorded every time it is scheduled, and the actual power Pwr_user at each time sampling point within the second time threshold T2 is acquired and stored in a second array AT2.

In an embodiment, the initial values of the elements in the first array AT1 and the second array AT2 are 0 by default. Since the discharge power is positive and the regenerative power is negative, in this embodiment, when the actual power Pwr_user>0, which means that it is in the discharge state, the values filled in the first array AT1 and the second array AT2 are equal to Pwr_user; when Pwr_user<0, which means that it is in the regenerative state, the values filled in the first array AT1 and the second array AT2 are equal to 0.

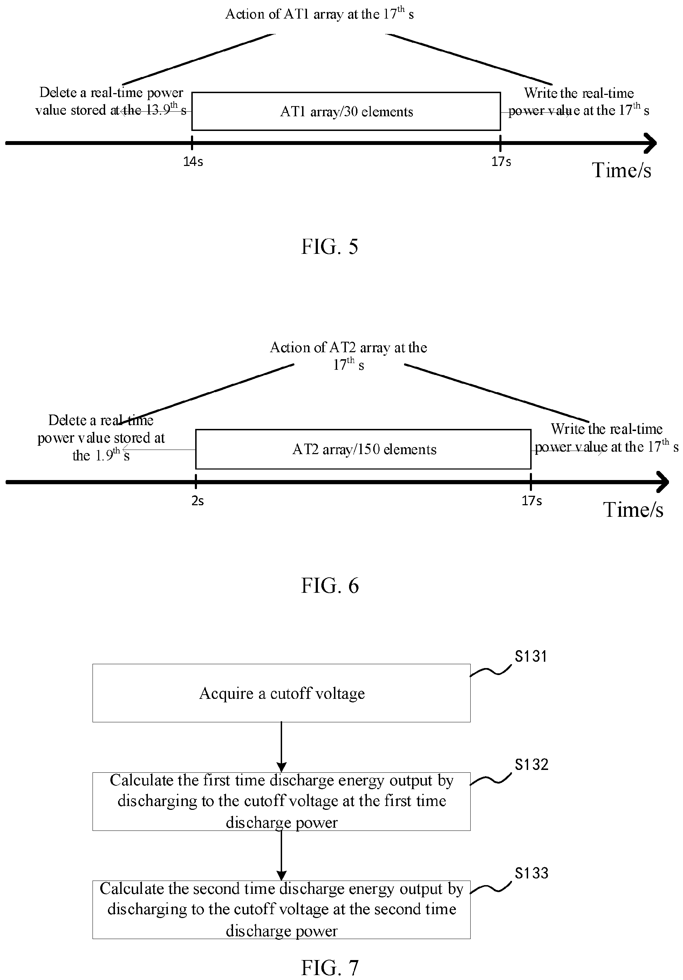

In an embodiment, referring to FIG. 5, it is a schematic diagram of data access of the first array AT1 corresponding to the first time threshold T1 in an embodiment of the present disclosure.

In FIG. 5, the first time threshold T1 is 3s, sampling is performed once every 0.1s, and the number of corresponding time sampling points is 30. Taking 14s to 17s as an example for illustration, at 17s, the first array AT1 deletes the actual power value stored at 13.9s, and the actual power value at 17s is written in. The first array AT1 contains 30 actual power Pwr_user.

Referring to FIG. 6, it is a schematic diagram of data access of the second array AT2 corresponding to the second time threshold T2 in an embodiment of the present disclosure.

In FIG. 6, the second time threshold T2 is 15s, sampling is performed once every 0.1s, and the number of corresponding time sampling points is 150. Taking 2s to 17s as an example for illustration, at 17s, the second array AT2 deletes the actual power value stored at 1.9s, and the actual power value at 17s is written in. The second array AT2 contains 150 actual power Pwr_user.

In an embodiment, after statistically obtaining the first array AT1 corresponding to the first time threshold T1, the actual power Pwr_user of the first array AT1 is summated to obtain the first discharge power integral value Area_T1 in step S122. The following takes the number of time sampling points of the first time threshold T1 as 30 as an example to illustrate the calculation process, which is expressed as:

$$Area\_T1 = \sum_{j=0}^{29} AT1(j) * \text{scheduling cycle}$$

Correspondingly, in an embodiment, after statistically obtaining the second array AT2 corresponding to the second time threshold T2, the actual power Pwr_user of the second array AT2 is summated to obtain the second discharge power integral value Area_T2 in step S124. The following takes the number of time sampling points of the second time threshold T2 as 150 as an example to illustrate the calculation process, which is expressed as:

$$Area\_T2 = \sum_{j=0}^{149} AT2(j) * \text{scheduling cycle}$$

In an embodiment, after obtaining the above discharge power integral value, discharge energy is then calculated.

Step S130: discharge energy is calculated according to the power information.

In an embodiment, the discharge energy includes: first time discharge energy Pwr_Sht_Area corresponding to the first time discharge power Pwr_S1 and second time discharge energy Pwr_Lng_Area corresponding to the second time discharge power Pwr_S2.

Referring to FIG. 7, step S130 includes, but is not limited to, step S131 to step S133.

Step S131, a cutoff voltage is acquired.

Step S132, the first time discharge energy output by discharging to the cutoff voltage at the first time discharge power is calculated.

Step S133, the second time discharge energy output by discharging to the cutoff voltage at the second time discharge power is calculated.

In an embodiment, the first time discharge energy Pwr_Sht_Area is the total energy released during the process of discharging to the cutoff voltage at the first time discharge power Pwr_S1. The calculation process is expressed as:

$$Pwr\_Sht\_Area = Pwr\_S1 * t1$$

In an embodiment, when the first preset time t1 is 2s, Pwr_Sht_Area=Pwr_S1*2.

Similarly, in an embodiment, the second time discharge energy Pwr_Lng_Area is the total energy released during the process of discharging to the cutoff voltage at the second time discharge power Pwr_S2. The calculation process is expressed as:

$$Pwr\_Lng\_Area = Pwr\_S2 * t2$$

In an embodiment, when the second preset time t2 is 10s, Pwr_Lng_Area=Pwr_S1*10.

After obtaining the discharge power integral value and the discharge energy through the above embodiment, the following steps may be performed to determine whether or not to perform power adjustment.

Step S140, it is determined whether a power regulation condition is met based on the discharge power integral value and the discharge energy.

Step S150, the maximum allowable output voltage is adjusted based on the power regulation condition.

In an embodiment, if the power regulation condition is met, the maximum allowable output power is adjusted from the first time discharge power to the second time discharge power, or the maximum allowable output power is adjusted from the second time discharge power to the first time discharge power.

In an embodiment, the power regulation condition includes: a first power regulation condition and a second power regulation condition. If the first power regulation condition is met, the maximum allowable output power is adjusted from the first time discharge power to the second time discharge power. If the second power regulation condition is met, the maximum allowable output power is adjusted from the second time discharge power to the first time discharge power.

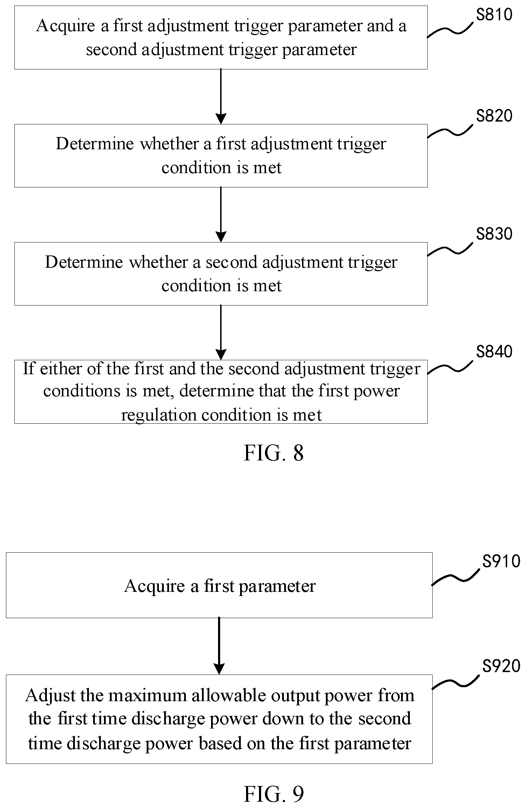

In an embodiment, when the power regulation condition is the first power regulation condition, referring to FIG. 8, step S140 includes, but is not limited to, step S810 to step S840.

Step S810, a first adjustment trigger parameter and a second adjustment trigger parameter are acquired.

In an embodiment, the first adjustment trigger parameter A and the second adjustment trigger parameter B are both percentages, less than 100%, may be calibrated according to actual needs or prior knowledge obtained from actual test data for different vehicle models, and are used to represent whether the process of dynamic adjustment of discharge power needs to be triggered.

Step S820, it is determined whether a first adjustment trigger condition is met.

In an embodiment, it is determined whether the first adjustment trigger condition is met based on the first discharge power integral value Area_T1, the first adjustment trigger parameter A and the first time discharge energy Pwr_Sht_Area. Meeting the first adjustment trigger condition is expressed as:

$$Area\_T1 > Pwr\_Sht\_Area * A$$

Step S830, it is determined whether a second adjustment trigger condition is met.

In an embodiment, it is determined whether the second adjustment trigger condition is met based on the second discharge power integral value Area_T2, the second adjustment trigger parameter B and the second time discharge energy Pwr_Lng_Area. Meeting the second adjustment trigger condition is expressed as:

$$Area\_T2 > Pwr\_Lng\_Area * B$$

In an embodiment, step S840 is used to determine whether the first power regulation condition is met.

Step S840, if either of the first adjustment trigger condition and the second adjustment trigger condition is met, the first power regulation condition is met.

In an embodiment, if either of the above first adjustment trigger condition and the second adjustment trigger condition is satisfied, it means that the first power regulation condition is met, and the discharge power is adjusted; otherwise, statistics related to the working state will continue until the first power regulation condition is met.

When the first power regulation condition is met, the maximum allowable output power is adjusted from the first time discharge power to the second time discharge power.

In an embodiment, the maximum allowable output power Pwr_BMS_Out is initially equal to the first time discharge power Pwr_S1. When the first power regulation condition is triggered, the power adjustment stage mainly involves adjusting the maximum allowable output power Pwr_BMS_Out from the first time discharge power Pwr_S1 to the second time discharge power Pwr_S2, that is, decreasing the maximum allowable output power Pwr_BMS_Out.

In an embodiment, referring to FIG. 9, when the power regulation condition is the first power regulation condition, step S150 includes, but is not limited to, step S910 to step S920.

Step S910, a first parameter is acquired.

Step S920, the maximum allowable output power is adjusted from the first time discharge power down to the second time discharge power based on the first parameter.

In this embodiment, since the first time discharge power Pwr_S1 is greater than the second time discharge power Pwr_S2, adjusting the maximum allowable output power Pwr_BMS_Out from the first time discharge power Pwr_S1 to the second time discharge power Pwr_S2 involves decreasing the value of the maximum allowable output power Pwr_BMS_Out. Therefore, the first parameter N1 is set according to the actual needs or prior knowledge obtained from the actual test data for different vehicle models, and the unit of this parameter is Kw/s. Then, the maximum allowable output power Pwr_BMS_Out is decreased from the first time discharge power Pwr_S1 down to the second time discharge power Pwr_S2 by using the first parameter N1.

It can be understood that the first parameter N1 in this embodiment should not be too small to prevent the entire vehicle from continuing to discharge at high power during the power adjustment stage, which could cause an undervoltage fault.

In an embodiment, after the short-term discharge is completed, the maximum allowable output power Pwr_BMS_Out is decreased to the second time discharge power Pwr_S2. In order to meet the next short-term high-power discharge requirements (such as secondary acceleration), the maximum allowable output power Pwr_BMS_Out needs to be increased again to the first time discharge power Pwr_S1. Specifically, the following step S160 to step S170 are used to recover the maximum allowable output power Pwr_BMS_Out to ensure vehicle driving performance and driving experience.

When the power regulation condition is the second power regulation condition, it is determined whether the second power regulation condition is met based on the discharge power integral value and the discharge energy.

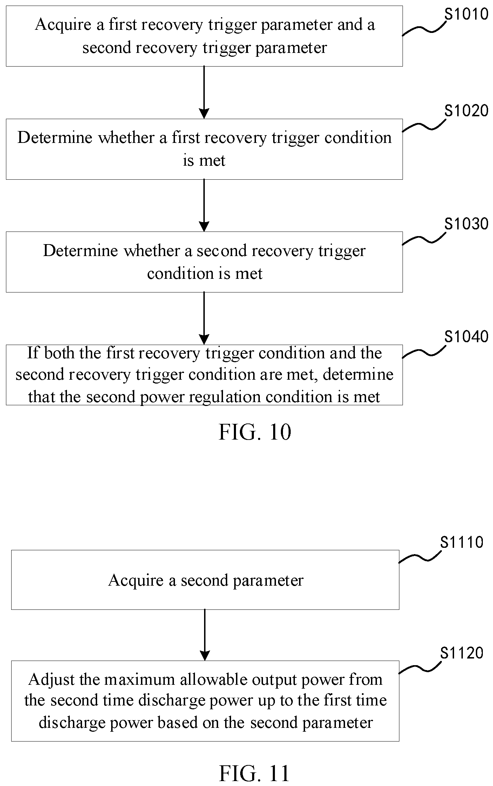

In an embodiment, referring to FIG. 10, when the power regulation condition is the second power regulation condition, step S140 includes, but is not limited to, step S1010 to step S1040.

Step S1010, a first recovery trigger parameter and a second recovery trigger parameter are acquired.

In an embodiment, the first recovery trigger parameter Recover_A and the second recovery trigger parameter Recover_B are both percentages, less than 100%, may be calibrated according to actual needs or prior knowledge obtained from actual test data for different vehicle models, and are used to characterize whether the process of dynamic adjustment of discharge power needs to be recover.

Step S1020, it is determined whether a first recovery trigger condition is met.

In an embodiment, it is determined whether the first recovery trigger condition is met based on the first discharge power integral value Area_T1, the first recovery trigger parameter Recover_A, and the first time discharge energy Pwr_Sht_Area. Meeting the first recovery trigger condition is expressed as:

$$Area\_T1 < Pwr\_Sht\_Area * Recover\_A$$

Step S1030, it is determined whether a second recovery trigger condition is met.

In an embodiment, it is determined whether the second recovery trigger condition is met based on the second discharge power integral value Area_T2, the second recovery trigger parameter Recover_B, and the second time discharge energy Pwr_Lng_Area. Meeting the second recovery trigger condition is expressed as:

$$Area\_T2 < Pwr\_Lng\_Area * Recover\_B$$

In an embodiment, step S1040 is used to determine whether the second power regulation condition is met.

Step S1040, if both the first recovery trigger condition and the second recovery trigger condition are met, the second power regulation condition is met.

In an embodiment, if the above first recovery trigger condition and the second recovery trigger condition are both satisfied, it means that the second power regulation condition is met, and the power adjustment process is recovered; otherwise, the waiting continues until the second power regulation condition is met.

When the second power regulation condition is met, the maximum allowable output power is adjusted from the second time discharge power to the first time discharge power.

In an embodiment, after power adjustment, the maximum allowable output power Pwr_BMS_Out is equal to the second time discharge power Pwr_S2. When the second power regulation condition is triggered, the power adjustment stage mainly involves recovering the maximum allowable output power Pwr_BMS_Out from the second time discharge power Pwr_S2 to the first time discharge power Pwr_S1, that is, increasing the maximum allowable output power Pwr_BMS_Out.

Referring to FIG. 11, when the power regulation condition is the second power regulation condition, step S150 includes, but is not limited to, step S1110 to step S1120.

Step S1110, a second parameter is acquired.

Step S1120, the maximum allowable output power is adjusted from the second time discharge power up to the first time discharge power based on the second parameter.

In this embodiment, since the first time discharge power Pwr_S1 is greater than the second time discharge power Pwr_S2, adjusting the maximum allowable output power Pwr_BMS_Out from the second time discharge power Pwr_S2 to the first time discharge power Pwr_S1 involves increasing the value of the maximum allowable output power Pwr_BMS_Out. Therefore, the second parameter N2 is set according to actual needs or prior knowledge obtained from actual test data for different vehicle models, and the unit of this parameter is Kw/s. Then, the second parameter N2 is used to increase the maximum allowable output power Pwr_BMS_Out from the second time discharge power Pwr_S2 to the first time discharge power Pwr_S1.

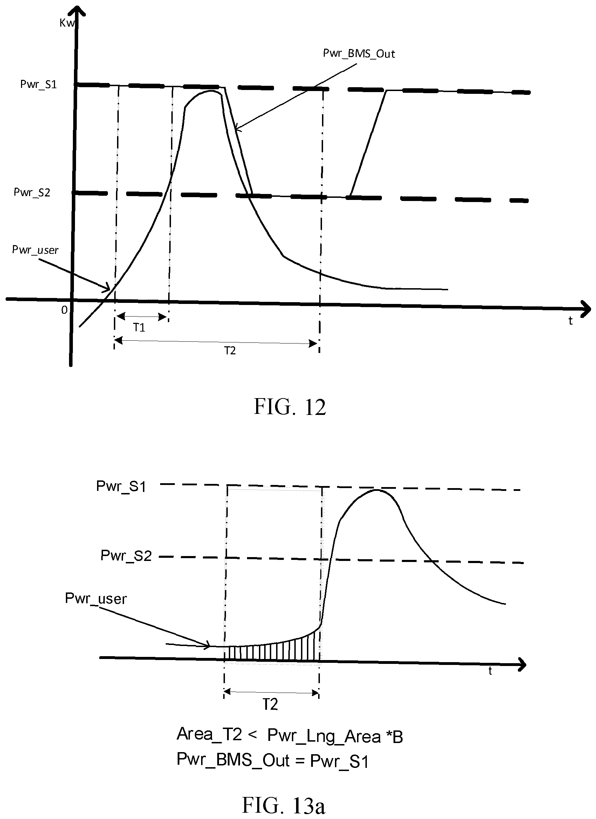

Referring to FIG. 12 showing a schematic diagram of power information in an embodiment of the present disclosure, the method for dynamically adjusting power in this embodiment is a method for dynamically adjusting the maximum allowable output power Pwr_BMS_Out based on the first time discharge power Pwr_S1 and the second time discharge power Pwr_S2 by monitoring the actual state of the current battery in real time, such as the state of charge (SOC) of the battery, and the ambient temperature of the battery, combined with the current operating state of the entire vehicle and the actual power usage. FIG. 12 illustrates the first time discharge power Pwr_S1, the second time discharge power Pwr_S2, the maximum allowable output power Pwr_BMS_Out, the actual power Pwr_user, the first time threshold T1, and the second time threshold T2.

In this embodiment, in a first aspect, since the first preset time t1 is less than the second preset time t2, the corresponding first time discharge power Pwr_S1 is greater than the second time discharge power Pwr_S2. In a second aspect, the maximum allowable output power Pwr_BMS_Out represents the maximum allowable discharge power output in the battery management system, used to limit the maximum discharge power that the vehicle control unit (VCU) can output. Therefore, the actual power Pwr_user can never be higher than the maximum allowable output power Pwr_BMS_Out. In addition, the initial value of the maximum allowable output power Pwr_BMS_Out is the first time discharge power Pwr_S1. Therefore, the above different powers satisfy the following relationship:

$$Pwr\_S1 > Pwr\_S2$$

$$Pwr\_user <= Pwr\_BMS\_Out$$

In the context of the vehicle's secondary acceleration process, the following description outlines the trend of actual power change as the vehicle transitions from a constant speed state to a low-power discharge state, and then to a high-power discharge state during acceleration.

When the entire vehicle is discharging (such as in the acceleration state or constant speed state), the motor requests a discharge power A' from the battery management system. The actual power Pwr_user is controlled together by the discharge power A' requested by the motor and the maximum allowable output power Pwr_BMS_Out output by the battery management system. For example, the actual power Pwr_user, which is the final discharge power of the motor, takes the minimum value of the discharge power A' requested by the motor and the maximum allowable output power Pwr_BMS_Out. The maximum allowable output power Pwr_BMS_Out output by the battery management system may also be described as the maximum target discharge power that the battery can provide to the motor. The present application prevents continuous high-power discharge of the entire vehicle, i.e., the actual power Pwr_user increases to a certain value and is sustained, which could lead to an undervoltage fault due to deep discharge, affecting the driving experience and accelerating the aging of the battery.

In order to avoid undervoltage caused by high-power long-term discharge, in this embodiment, the first power regulation condition is triggered to decrease the maximum allowable output power Pwr_BMS_Out output by the battery management system before pre-undervoltage. Decreasing the maximum allowable output power Pwr_BMS_Out may be considered theoretically that the discharge power of the motor is decreased, thereby avoiding the problem of undervoltage. One purpose of dynamically adjusting power in this embodiment is to decrease the discharge power of the motor by decreasing the maximum allowable output power Pwr_BMS_Out, which is manifested in the fact that the actual power Pwr_user increases to a certain value and then decreases after maintaining the value for a period of time.

In this embodiment, after the second acceleration of the entire vehicle is completed, the second power regulation condition is triggered to recover the maximum allowable output power Pwr_BMS_Out output by the battery management system and increase the maximum allowable output power Pwr_BMS_Out, thereby increasing the actual power Pwr_user and ensuring the vehicle driving performance and driving experience.

In an embodiment, in order to meet the short-term high power output, the maximum allowable output power Pwr_BMS_Out is the first time discharge power. After the short-term high power output is completed, the maximum allowable output power Pwr_BMS_Out is adjusted from the first time discharge power to the second time discharge power if the first power regulation condition is met, which avoids the problem of the battery discharged to cause undervoltage while meeting the requirements for short-term high-power discharge. If it is detected that the second power regulation condition is met, the maximum allowable output power Pwr_BMS_Out is adjusted from the second time discharge power to the first time discharge power, so as to meet the requirements of the subsequent short-term high-power discharge. The maximum allowable output power is adjusted between the short-term discharge power and the long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle.

FIG. 13a to FIG. 13c are schematic diagrams of dynamically adjusting power in an embodiment of the present disclosure.

FIG. 13a to FIG. 13c take the second time threshold T2 as an example for illustration. The first time threshold T1 is not shown, but it does not mean that the entire power adjustment process is merely related to the second time threshold T2. The second time threshold T2 in the figures is a sliding window. Through real-time statistics, the accumulated amount of actual powers Pwr_user within the second time threshold T2 is the second discharge power integral value Area_T2, and based on the relationship between the second discharge power integral value Area_T2 and the theoretically releasable total energy, that is, the second time discharge energy Pwr_Lng_Area, it can determined whether the first power regulation condition or the second power regulation condition is met, thereby controlling the maximum allowable output power Pwr_BMS_Out output by the battery management system, and further achieving the purpose of controlling the actual power Pwr_user. The area enclosed by the actual power Pwr_user and a time axis t in the figures can represent the second discharge power integral value Area_T2 within the second time threshold T2.

Referring to FIG. 13a, what is simulated is a constant speed state of the entire vehicle. In this case, the actual power Pwr_user of the entire vehicle is relatively stable, and the actual power Pwr_user is less than the second time discharge power Pwr_S2, and the second discharge power integral value Area_T2 is less than the second time discharge energy Pwr_Lng_Area*B, that is, the first power regulation condition is not triggered. At this time, the maximum allowable output power Pwr_BMS_Out is equal to the first time discharge power Pwr_S1, and the battery management system allows the entire vehicle to perform short-term high-power discharge.

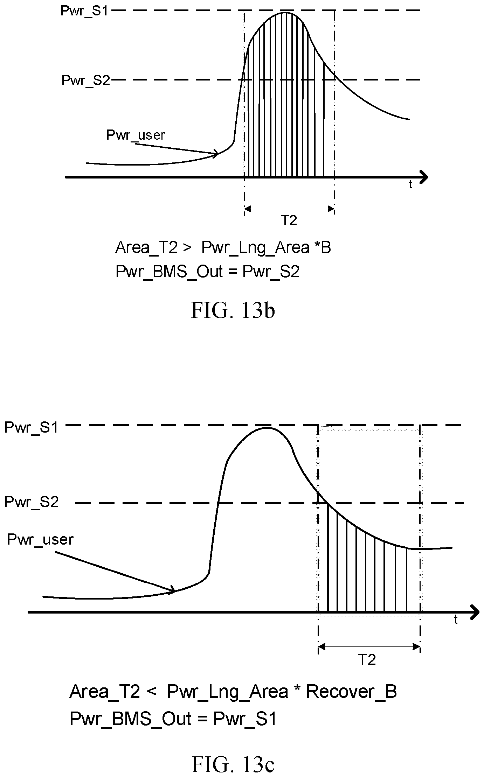

Referring to FIG. 13b, what is simulated is the acceleration state of the entire vehicle. When in the acceleration state, the entire vehicle will discharge with greater power. In order to prevent the battery from being discharged to cause undervoltage due to long-term high-power discharge, it is necessary to control the actual power Pwr_user of the entire vehicle by controlling the maximum allowable output power Pwr_BMS_Out. The method for dynamically adjusting discharge power is triggered in this state. When it is detected Area_T2>Pwr_Lng_Area*B, the first power regulation condition is triggered, and the maximum allowable output power Pwr_BMS_Out decreases from the first time discharge power Pwr_S1 to the second time discharge power Pwr_S2 at a certain rate (for example, N1). At this stage, the battery management system does not allow the entire vehicle to perform short-term high-power discharge.

Referring to FIG. 13c, when the vehicle speed remains constant, the power used by the entire vehicle to maintain this state is not significant. If the first recovery trigger condition Area_T1<Pwr_Lng_Area*Recover_A and the second recovery trigger condition Area_T2<Pwr_Lng_Area*Recover_B are all met, it means that the battery management system allows the entire vehicle to perform short-term high-power discharge, and the maximum allowable output power Pwr_BMS_Out recovers from the second time discharge power Pwr_S2 to the first time discharge power Pwr_S1 at a certain rate (such as N2). On the contrary, it means that the battery management system does not allow the vehicle to perform short-term high-power discharge, and it needs to continue to wait for the opportunity for power recovery.

The embodiments mainly introduce short-term discharge power for driving requirements to improve the acceleration performance of the entire vehicle, and combine it with a method for dynamically adjusting power to achieve dynamic adjustment between the short-term discharge power and long-term discharge power. This prevents undervoltage that may arise from long-term high-power discharge due to the introduction of short-term discharge power. In the embodiments, power information is acquired, a discharge power integral value within a preset time threshold is calculated, discharge energy is calculated according to the power information, and it is determined whether it is necessary to adjust the maximum allowable output power from first time discharge power to second time discharge power, or to adjust the maximum allowable output power from the second time discharge power to the first time discharge power based on the discharge power integral value and the discharge energy. According to the embodiments, the maximum allowable output power is adjusted between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle.

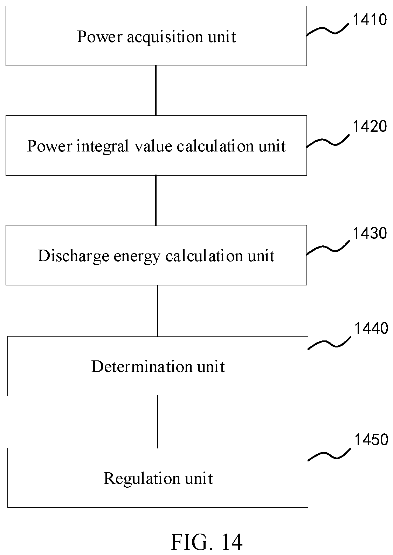

An embodiment of the present disclosure also provides an apparatus for dynamically adjusting power, which can implement the above method for dynamically adjusting power. Referring to FIG. 14, the apparatus includes:

a power acquisition unit 1410, configured to acquire power information, the power information including a first time discharge power, a second time discharge power, and a maximum allowable output power;

a power integral value calculation unit 1420, configured to calculate a discharge power integral value within a preset time threshold;

a discharge energy calculation unit 1430, configured to calculate a discharge energy according to the power information;

a determination unit 1440, configured to determine whether a power regulation condition is met based on the discharge power integral value and the discharge energy; and

a regulation unit 1450, configured to adjust the maximum allowable output power from the first time discharge power to the second time discharge power or adjust the maximum allowable output power from the second time discharge power to the first time discharge power if the power regulation condition is met.

In an embodiment, the power regulation condition includes a first power regulation condition and a second power regulation condition. When the first power regulation condition is met, the maximum allowable output power is adjusted from the first time discharge power to the second time discharge power. When the second power regulation condition is met, the maximum allowable output power is adjusted from the second time discharge power to the first time discharge power.

The specific implementation of the apparatus for dynamically adjusting power in this embodiment is basically the same as the specific implementation of the method for dynamically adjusting power, which will not be described again here.

An embodiment of the present disclosure also provides a storage medium. The storage medium is a computer-readable storage medium that stores computer-executable instructions, and the computer-executable instructions are used to cause a computer to perform the above method for dynamically adjusting power.

According to the method for dynamically adjusting power, the apparatus for dynamically adjusting power, the electronic device, and the storage medium provided by the embodiments of the present disclosure, power information is acquired, a discharge power integral value within a preset time threshold is calculated, discharge energy is calculated according to the power information, and it is determined whether it is necessary to adjust the maximum allowable output power from a first time discharge power to a second time discharge power, or to adjust the maximum allowable output power from the second time discharge power to the first time discharge power based on the discharge power integral value and the discharge energy. According to the embodiments, the maximum allowable output power is adjusted between short-term discharge power and long-term discharge power by detecting the actual state of the current battery and combining the current actual power information, which, on the premise of protecting the battery, meets the power requirements of the entire vehicle under different working conditions, thereby improving the driving experience, slowing down the aging of the battery, and prolonging the service life of the vehicle.

As a non-transitory computer-readable storage medium, the memory may be used to store non-transitory software programs and non-transitory computer-executable programs. In addition, the memory may include a high-speed random access memory and may also include a non-transitory memory, such as at least one magnetic disk storage device, flash memory device, or other non-transitory solid-state storage device. In some implementations, the memory may optionally include memories located remotely from the processor, and these remote memories may be connected to the processor via a network. Examples of the above network include, but are not limited to, the Internet, intranets, local area networks, mobile communication networks and combinations thereof.

The embodiments of the present disclosure described above are to more clearly illustrate the technical solutions of the embodiments of the present disclosure, and do not constitute a limitation on the technical solutions provided by the embodiments of the present disclosure. Those of ordinary skills in the art will know that with the evolution of technology and the emergence of new application scenarios, the technical solutions provided by the embodiments of the present disclosure are also applicable to similar technical problems.

Those of ordinary skills in the art can understand that the technical solutions shown in FIGS. 1-14 do not limit the embodiments of the present disclosure, and may include more or fewer steps than shown in the figures, or combine certain steps, or have different steps.

The apparatus embodiments described above are merely illustrative, and the units described as separate components may or may not be physically separated, that is, they may be located in one place or may be distributed to a plurality of network units. Some or all of the modules may be selected according to actual needs to achieve the purpose of the solutions of the embodiments.

Those of ordinary skill in the art can understand that all or some steps in the methods, and functional modules/units in the systems and devices disclosed above may be implemented as software, firmware, hardware, and appropriate combinations thereof.

The terms "first", "second", "third", "fourth", etc. (if present) in the specification of the present disclosure and the above accompanying drawings are used to distinguish similar objects and are not necessarily used to describe specific order or sequence. It is to be understood that the data so used are interchangeable under appropriate circumstances, so that the embodiments of the present disclosure described herein can be practiced in sequences other than those illustrated or described herein. In addition, the terms "including" and "having" and any variations thereof are intended to cover non-exclusive inclusions. For example, processes, methods, systems, products or devices that include a series of steps or units need not be limited to those clearly listed, but may include other steps or units that are not clearly listed or that are inherent to those processes, methods, products or devices.

It is to be understood that in the present disclosure, "at least one (item)" refers to one or more, and "plurality" refers to two or more. "And/or" is used to describe the relationship between associated objects, indicating that there may be three relationships. For example, "A and/or B" may indicate: only A, only B, and both A and B. A and B may be singular or plural. The character "/" generally indicates that the related objects are in an "or" relationship. "At least one of the following" or similar expressions thereof refers to any combination of these items, including any combination of a single item or a plurality of items. For example, at least one of a, b, or c may indicate a, b, c, "a and b", "a and c", "b and c", or "a and b and c", where a, b, c may be singular or plural.

In several embodiments provided by the present disclosure, it is to be understood that the disclosed apparatus and method may be implemented in other ways. For example, the apparatus embodiments described above are merely illustrative. For example, the division of the units is merely a logical function division. In actual implementation, there may be other division methods. For example, a plurality of units or components may be combined or may be integrated into another system, or some features may be ignored, or not implemented. On the other hand, the coupling or direct coupling or communication connection between each other shown or discussed may be indirect coupling or communication connection through some interfaces, apparatuses or units, which may be in electrical, mechanical or other forms.

The units described as separate components may or may not be physically separated, and the components shown as units may or may not be physical units, that is, they may be located in one place or may be distributed to a plurality of network units. Some or all of the units may be selected according to actual needs to achieve the purpose of the solutions of the embodiments.

In addition, each functional unit in various embodiments of the present disclosure may be integrated into one processing unit, or each unit can exist physically alone, or two or more units may be integrated into one unit. The above integrated units may be implemented in the form of hardware or software functional units.

If the integrated units are implemented in the form of the software functional units and sold or used as an independent product, they may be stored in a computer-readable storage medium. Based on this understanding, the technical solutions of the present disclosure, or the part that contributes to the existing technology, or all or part of the technical solutions may be essentially embodied in the form of a software product, and the computer software product is stored in a storage medium, including a plurality of instructions for causing an electronic device (which may be a personal computer, a server, or a network device, etc.) to execute all or part of the steps of the method described in various embodiments of the present disclosure. The aforementioned storage medium includes: a USB flash disk, a mobile hard disk, a Read-Only Memory (ROM), a Random Access Memory (RAM), a magnetic disk or optical disk and other media that can store programs.

The preferred embodiments of the embodiments of the present disclosure have been described above with reference to the accompanying drawings, which, however, do not limit the scope of the embodiments of the present disclosure. Any modifications, equivalent substitutions and improvements made by those of ordinary skills in the art without departing from the scope and essence of the embodiments of the present disclosure shall be within the scope of the embodiments of the present disclosure.

**Claims**

1. A method for dynamically adjusting power, comprising:

   acquiring power information, the power information comprising a first time discharge power, a second time discharge power, and a maximum allowable output power;
   calculating a discharge power integral value within a preset time threshold;
   calculating a discharge energy according to the power information;
   determining whether a power regulation condition is met based on the discharge power integral value and the discharge energy; and
   adjusting the maximum allowable output power from the first time discharge power to the second time discharge power or adjusting the maximum allowable output power from the second time discharge power to the first time discharge power in response to the power regulation condition being met.

2. The method for dynamically adjusting power according to claim 1, wherein the acquiring power information comprises:

   acquiring a current working state and a cutoff voltage, the current working state comprising: a current state of charge and a current working temperature;
   calculating a power value required to continuously discharge to the cutoff voltage within first preset time in the current working state as the first time discharge power; and
   calculating a power value required to continuously discharge to the cutoff voltage within second preset time in the current working state as the second time discharge power, the first preset time being shorter than the second preset time.

3. The method for dynamically adjusting power according to claim 1, wherein the preset time threshold comprises: a first time threshold and a second time threshold; the discharge power integral value comprises: a first discharge power integral value and a second discharge power integral value; the calculating a discharge power integral value within a preset time threshold comprises:

   acquiring an actual power at each time sampling point within the first time threshold;
   summating the actual power within the first time threshold to obtain the first discharge power integral value;
   acquiring an actual power at each time sampling point within the second time threshold; and
   summating the actual power within the second time threshold to obtain the second discharge power integral value.

4. The method for dynamically adjusting power according to claim 3, wherein the discharge energy comprises: first time discharge energy and second time discharge energy corresponding to the first time discharge power and the second time discharge power, respectively; the calculating a discharge energy according to the power information comprises:

   acquiring a cutoff voltage;
   calculating the first time discharge energy output by discharging to the cutoff voltage at the first time discharge power; and
   calculating the second time discharge energy output by discharging to the cutoff voltage at the second time discharge power.

5. The method for dynamically adjusting power according to claim 4, wherein the power regulation condition comprises a first power regulation condition; the determining whether a power regulation condition is met based on the discharge power integral value and the discharge energy comprises:

acquiring a first adjustment trigger parameter and a second adjustment trigger parameter;

determining whether a first adjustment trigger condition is met based on the first discharge power integral value, the first adjustment trigger parameter, and the first time discharge energy;

determining whether a second adjustment trigger condition is met based on the second discharge power integral value, the second adjustment trigger parameter, and the second time discharge energy; and

determining that the first power regulation condition is met in response to either of the first adjustment trigger condition and the second adjustment trigger condition being met.

6. The method for dynamically adjusting power according to claim 5, wherein in case that the first power regulation condition is met, the adjusting the maximum allowable output power from the first time discharge power to the second time discharge power comprises:

acquiring a first parameter; and

adjusting the maximum allowable output power from the first time discharge power down to the second time discharge power based on the first parameter.

7. The method for dynamically adjusting power according to claim 1, wherein the power regulation condition comprises a second power regulation condition; the determining whether a power regulation condition is met based on the discharge power integral value and the discharge energy comprises:

acquiring a first recovery trigger parameter and a second recovery trigger parameter;

determining, based on the first discharge power integral value, the first recovery trigger parameter and the first time discharge energy, whether a first recovery trigger condition is met;

determining, based on the second discharge power integral value, the second recovery trigger parameter, and the second time discharge energy, whether the second recovery trigger condition is met; and

in response to both the first recovery trigger condition and the second recovery trigger condition being met, determining that the second power regulation condition is met.

8. The method for dynamically adjusting power according to claim 7, wherein in case that the second power regulation condition is met, the adjusting the maximum allowable output power from the second time discharge power to the first time discharge power comprises:

acquiring a second parameter; and

adjusting the maximum allowable output power from the second time discharge power up to the first time discharge power based on the second parameter.

9. An apparatus for dynamically adjusting power, comprising:

a power acquisition unit, configured to acquire power information, the power information comprising a first time discharge power, a second time discharge power, and a maximum allowable output power;

a power integral value calculation unit, configured to calculate a discharge power integral value within a preset time threshold;

a discharge energy calculation unit, configured to calculate a discharge energy according to the power information;

a determination unit, configured to determine whether a power regulation condition is met based on the discharge power integral value and the discharge energy; and

a regulation unit, configured to adjust the maximum allowable output power from the first time discharge power to the second time discharge power or adjust the maximum allowable output power from the second time discharge power to the first time discharge power in response to the power regulation condition being met.

10. A battery management system, comprising: a processor and a memory;

the memory being configured to store programs;

the processor being configured to execute, according to the programs, the method for dynamically adjusting power according to any one of claims 1 to 8 to adjust a power of a battery.

11. A computer-readable storage medium, storing computer-executable instructions, the computer-executable instructions being used to execute the method for dynamically adjusting power according to any one of claims 1 to 8.

12. A vehicle, comprising:

a battery; and
the battery management system according to claim 10, the battery management system being electrically connected to the battery.

100

110

Processor

Memory

120

FIG. 1

Acquire power information — S110

Calculate a discharge power integral value within a preset time threshold — S120

Calculate a discharge energy according to the power information — S130

Determine whether a power regulation condition is met based on the discharge power integral value and the discharge energy — S140

Adjust the maximum allowable output voltage according to the power regulation condition — S150

FIG. 2

Acquire a current working state and a cutoff voltage　S111

Calculate a first time discharge power　S112

Calculate a first time discharge power　S113

## FIG. 3

Acquire an actual power at each time sampling point within the first time threshold　S121

Summate the actual power within the first time threshold to obtain the first discharge power integral value　S122

Acquire an actual power at each time sampling point within the second time threshold　S123

Summate the actual power within the second time threshold to obtain the second discharge power integral value　S124

## FIG. 4

Action of AT1 array at the 17$^{th}$ s

Delete a real-time power value stored at the 13.9$^{th}$ s

AT1 array/30 elements

Write the real-time power value at the 17$^{th}$ s

14s     17s     Time/s

FIG. 5

Action of AT2 array at the 17$^{th}$ s

Delete a real-time power value stored at the 1.9$^{th}$ s

AT2 array/150 elements

Write the real-time power value at the 17$^{th}$ s

2s     17s     Time/s

FIG. 6

Acquire a cutoff voltage — S131

Calculate the first time discharge energy output by discharging to the cutoff voltage at the first time discharge power — S132

Calculate the second time discharge energy output by discharging to the cutoff voltage at the second time discharge power — S133

FIG. 7

Acquire a first adjustment trigger parameter and a second adjustment trigger parameter ⟞ S810

Determine whether a first adjustment trigger condition is met ⟞ S820

Determine whether a second adjustment trigger condition is met ⟞ S830

If either of the first and the second adjustment trigger conditions is met, determine that the first power regulation condition is met ⟞ S840

FIG. 8

Acquire a first parameter ⟞ S910

Adjust the maximum allowable output power from the first time discharge power down to the second time discharge power based on the first parameter ⟞ S920

FIG. 9

Acquire a first recovery trigger parameter and a
second recovery trigger parameter

S1010

Determine whether a first recovery trigger condition
is met

S1020

Determine whether a second recovery trigger
condition is met

S1030

If both the first recovery trigger condition and the
second recovery trigger condition are met, determine
that the second power regulation condition is met

S1040

FIG. 10

Acquire a second parameter

S1110

Adjust the maximum allowable output power from
the second time discharge power up to the first time
discharge power based on the second parameter

S1120

FIG. 11

FIG. 12

Area_T2 < Pwr_Lng_Area *B
Pwr_BMS_Out = Pwr_S1

FIG. 13a

Pwr_S1

Pwr_S2

Pwr_user

T2

Area_T2 > Pwr_Lng_Area *B
Pwr_BMS_Out = Pwr_S2

FIG. 13b

Pwr_S1

Pwr_S2

Pwr_user

T2

Area_T2 < Pwr_Lng_Area * Recover_B
Pwr_BMS_Out = Pwr_S1

FIG. 13c

Power acquisition unit ⟋ 1410

Power integral value calculation unit ⟋ 1420

Discharge energy calculation unit ⟋ 1430

Determination unit ⟋ 1440

Regulation unit ⟋ 1450

FIG. 14

## INTERNATIONAL SEARCH REPORT

| International application No. |
| --- |
| **PCT/CN2023/104958** |

| A. | CLASSIFICATION OF SUBJECT MATTER |
| --- | --- |
| | H02J7/00(2006.01)i; H01M10/44(2006.01)i; B60L58/10(2019.01)i |

According to International Patent Classification (IPC) or to both national classification and IPC

| B. | FIELDS SEARCHED |
| --- | --- |

Minimum documentation searched (classification system followed by classification symbols)

H02J; H01M; B60L

Documentation searched other than minimum documentation to the extent that such documents are included in the fields searched

Electronic data base consulted during the international search (name of data base and, where practicable, search terms used)

CNABS, CNTXT, USTXT, WOTXT, EPTXT, VEN, CNKI, IEEE: 动态, 功率, 能量, 调整, 调节, 放电, 极限, 最大, 积分, 时间, dynamic, power, energy, adjustment, regulation, discharge, limit, maximum, integration, time

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 115395601 A (SUNWODA ELECTRIC VEHICLE CELL CO., LTD.) 25 November 2022 (2022-11-25)<br>  claims 1-12 | 1-12 |
| X | CN 114475349 A (BEIQI FOTON MOTOR CO., LTD.) 13 May 2022 (2022-05-13)<br>  description, paragraphs 0075-0205, and figures 1-3 | 1-12 |
| X | CN 114771344 A (GREAT WALL MOTOR COMPANY LIMITED) 22 July 2022 (2022-07-22)<br>  description, paragraphs 0086-0223, and figures 1-7 | 1-12 |
| A | CN 110293879 A (ZHEJIANG FEIDIE AUTOMOBILE MANUFACTURING CO., LTD. et al.) 01 October 2019 (2019-10-01)<br>  entire document | 1-12 |
| A | CN 111890985 A (HANTENG AUTOMOBILE CO., LTD.) 06 November 2020 (2020-11-06)<br>  entire document | 1-12 |
| A | US 2020185944 A1 (HYUNDAI MOTOR COMPANY et al.) 11 June 2020 (2020-06-11)<br>  entire document | 1-12 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 September 2023** | **26 September 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/104958**

| Patent document cited in search report | | | Publication date (day/month/year) | Patent family member(s) | | | Publication date (day/month/year) |
|---|---|---|---|---|---|---|---|
| CN | 115395601 | A | 25 November 2022 | None | | | |
| CN | 114475349 | A | 13 May 2022 | None | | | |
| CN | 114771344 | A | 22 July 2022 | None | | | |
| CN | 110293879 | A | 01 October 2019 | None | | | |
| CN | 111890985 | A | 06 November 2020 | None | | | |
| US | 2020185944 | A1 | 11 June 2020 | US | 11183862 | B2 | 23 November 2021 |
| | | | | KR | 20200075098 | A | 26 June 2020 |

Form PCT/ISA/210 (patent family annex) (July 2022)